# EUROPEAN PATENT SPECIFICATION

(11) **EP 3 012 059 B1**
(45) Date of publication and mention of the grant of the patent: **18.10.2017**
(21) Application number: 15186879.1
(22) Date of filing: 25.09.2015
(51) Int. Cl.: B23K 26/00, B23K 26/26, B23K 26/324, B23K 26/362, B23K 26/38, B23K 26/20, C03B 23/203, B23K 26/244

(54) **METHOD TO PRODUCE A TRANSPARENT PIECE TO BE USED TO PROTECT AN OPTICAL COMPONENT**
VERFAHREN ZUR HERSTELLUNG EINES TRANSPARENTEN TEILS ZUM SCHUTZ EINER OPTISCHEN KOMPONENTE
PROCÉDÉ POUR PRODUIRE UN ÉLÉMENT TRANSPARENT DESTINÉ À ÊTRE UTILISÉ POUR PROTÉGER UN COMPOSANT OPTIQUE

(30) Priority: 26.09.2014 FI 20140257
(43) Date of publication of application: 27.04.2016
(73) Proprietor: Primoceler Oy, 33720 Tampere (FI)
(72) Inventor: MÄÄTTÄNEN, Antti, 33810 Tampere (FI)
(74) Representative: Berggren Oy, Tampere

(56) References cited:
- DE-A1-102010 038 554
- US-A1- 2010 047 587
- US-A1- 2012 234 048

## Description

The object of this invention is a method to produce a transparent piece to be used to protect an optical component which piece comprises at least one wall that is optically clear and that has planar surfaces, and a rim going round a certain surface of this wall, wherein a space is formed inside the dimensions of the piece such that the space is limited to said certain surface and to the inner surface of the rim.

The method includes steps of welding and cutting which are described for example in the patent document DE102010038554A1.

The usages of the invention are in the production of glass pieces, silicon pieces, and sapphire pieces, or pieces, which are combinations thereof, wherein the pieces are transparent for visible light, and the pieces are used for the protection and encapsulation of optical components.
CMOS sensors and various components of projectors may be mentioned as examples for said components. It is typical for these pieces that the surfaces of a certain wall are optically clear so that light is transmitted through them efficiently and without adverse refraction of the light.

The above-mentioned pieces are produced with the known technology so that first e.g. a rectangular piece of total height of the product is formed and then beginning from one of its sides a space is etched for the optical components to be used in connection of it and thus around of this space remains a part that is a rim surrounding this component and in one side remains a wall that is transparent for the light that is entering and leaving the optical component.

Another way to produce a piece of the object of the invention according to the known technology is to compose it of two parts. The first part is then a clear plate of glass, silicon or sapphire and the second part is a plate of glass, silicon or sapphire where there has been made an opening of suitable size for the optical component. These plates are placed upon each other, heated to the temperature of 400 - 1000 °C and pressed together. They stick to each other because of the temperature and pressing power and thus form a piece of desired shape.

The known technology that has been described above is used in the marked very widely when producing glass, silicon or sapphire contents pieces to be used in connection of the optical components.

The greatest drawback of the known technique can be seen that when using it it is very laborious and expensive and many times even impossible to achieve a desired level quality product. In this case, the quality means optically clear surfaces and flat surface that let the light penetrate sufficiently without problems. Clarity of the surface is of course a relative concept, but in this context the surface clarity that is reached in the ordinary industrial production of glass, silicon and sapphire may be considered to represent a sufficient surface clarity.

When using an etching method, the bottom (for instance the so called inside surface) of the space to be etched gets the shape of a cone, in which case light penetrating through the wall is not refracted without disturbance. It is also very challenging to achieve a sufficient surface clarity when using the etching method and it is then necessary to make compromises between the production costs and the surface clarity.

Another drawback of the known production method, that is pressing heated parts together is, that the heating causes heat stress in the plates that are used and they change uneven the wall of the object of the penetration of the light so that there comes disturbance in the reflection of the light. Even though it is possible to achieve a sufficient surface clarity in this method this advantage is lost when the surfaces become non-planar.

An object of the present invention is to provide a method to produce transparent pieces to be used to protect optical components that, such that the method avoids the drawbacks of the known technology. It is characteristic for the solution according to the invention that has been presented in the characterizing part of claim 1.

The most important advantage of the invention can be seen to be that pieces of glass, silicon and sapphire or combination of these materials produced according the method of the invention have a wall for transmitting light such that the surfaces of the wall are optically clear and planar, wherein light beams are transmitted through said wall as anticipated without disturbance.

In this document the term "segment welding" means all the welding that advances on a certain level, where no circumferential welding is formed by one welding. The term "transparent piece" means a piece that contains a transparent wall.

The invention is described in more detail in the enclosed drawings, where
figs 1 - 3 present one transparent piece to be used to protect an optical component,
fig 4 describes a setting where several above-mentioned pieces are produced at a time using the method of the invention,
fig 5 presents a cut detail drawing in fig 4 where the place "Area 1" is described,
fig 6 presents a sectional cut of the place "A-A".

Next, one for the invention favorable application is described referring to the above-mentioned drawings.

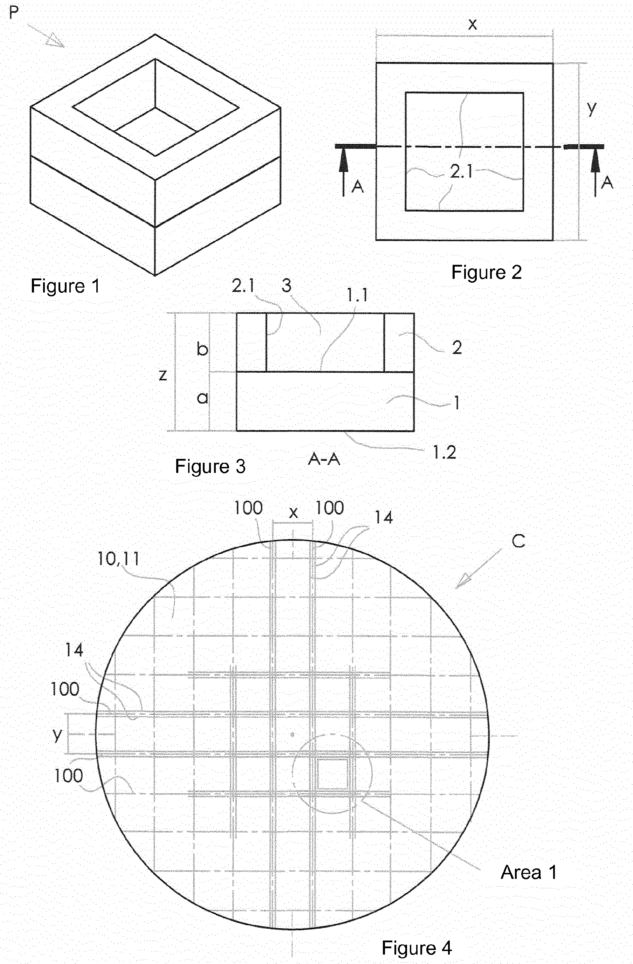

In figs 1 - 3 there is described as an example a piece P that has been produced using the method of the invention of material that in this example is glass. Fig 1 presents it in 3D, fig 2 directly from above and fig 3 cut A-A in the place indicated in fig 2. The piece P is rectangular and its outer dimensions are x, y and z. It has a square cross section in a plane defined by the x-direction and by the y-direction, and a hollow recession, i.e. a space 3 has been formed in the glass piece such that the space 3 extends from the other x-y-surface of the piece to the interior of the piece. When using the piece P an optical component is put into this space and it is possible to focus visible light to this component through certain part of the glass piece. In the piece P of this example this part is a wall 1, which the first surface 1.1 and the second surface 1.2, which are optically clear and planar. Around the first surface 1.1 there is a rim 2 that goes around it and thus the above-mentioned space 3 is formed inside the outer dimensions x,y,z of the piece such that the space 3 extends to the first surface 1.1 and to the inner surface 2.1 of the rim. The thickness of the wall 1 is in this case a and the height of the rim is b. The piece P is fastened to a usage object via the opposite surface of the rim 2, wherein said opposite surface is opposite to the wall 1.

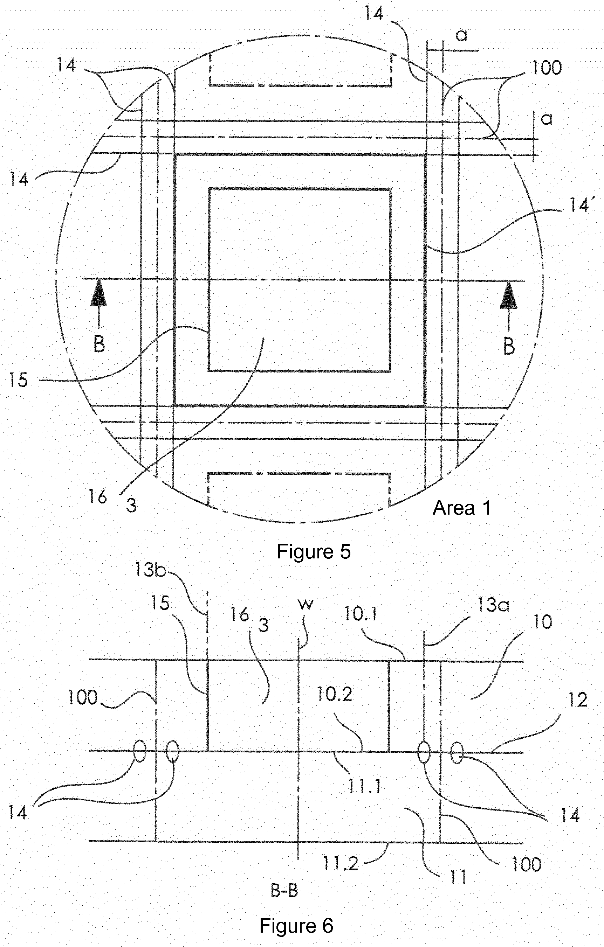

The before described piece P has been produced by an application of the method according to the invention as follows: According to the figs 4 - 6 two glass sheets, that is the first sheet 10 and the second sheet 11, have been placed upon each other upon a working underlay so that they have a common boundary surface 12. Said sheets are planar, optically clear and they will be welded together using a laser beam 13a that has been focused to the level of the boundary surface 12. It can be seen in the fig 4 that said sheets will be joined with welds 14 that extend essentially from one edge of the sheet pair to another edge of the sheet pair, said welds being segment welds crossing each other. In the combination C formed of the sheets 10, 11 there have been marked the lines to show cutting points 100 where the combination is cut into pieces in the last phase of the method according to the invention. The distance between the cutting lines in two perpendicular directions corresponds to the dimensions x, y of the above-mentioned piece P. The above-mentioned welds 14 are formed on both sides of said crossing points near them so that the welds 14 form several square-shaped circumferential welds 14'. The sides of these circumferential welds are at a certain distance from the crossing points 100 such that it is possible to cut loose from the combination C glass pieces, that is pieces P using some known technique method along these cutting points without causing damage to the circumferential welds 14'. It can be mentioned that economical values for the distance a can be 25-100 µm. However, this is not presented as a limitation for the usage of the invention but the value in question can always be selected case by case also outside this area. The circumferential weld 14' can be made gas tight or in some cases it can be made for instance even by using intermittent welding, and the issues of the usage of the piece P determine case by case the requirements for the welding.

In this example, in the next stage of the method a peripheral ablation is made inside each circumferential weld 14', more precisely inside the projection line in the thickness direction w of the sheets 10, 11 of this arc weld. The ablation is made using laser beam 13b so that it starts from the first surface 10.1 of the first sheet 10 and it is continued going along the periphery through this sheet to its second surface 10.2 and as a result of this ablation a gap 15 is formed inside the circumferential weld 14' through the first sheet 10 and inside it a loose part 16 from the first sheet. When this part 16 is taken away, a space 3 is formed in the combination C, the size of the space 3 being substantially equal to the size of the part 16. The bottom of this space 3 is optically clear and planar part of the first surface 11.1 of the second plane 11. When cutting is performed for the preform along the cutting points 100 a certain amount of pieces P get loose such that each has a wall 1 and a rim 2.

Naturally, the ablation can be done in some other way than before for the second sheet 11, when the first sheet 10 needs to be optically clear. Thus, at least the sheet used for producing the walls needs to be optically clear when the walls of the transparent pieces are formed from said sheet.

It is possible to produce, using the method of the invention, transparent pieces P where the raw material is glass, silicon or sapphire, or that are composed of more than one of these materials.

The method according to the invention is not limited to removing the part 6 and to forming the space 3 only in the way that has been described above using the ablation. To get loose this part 16 making the peripheral gap 15 can also be reached by other ways, like for example mechanically cutting or by using some other kind of laser technique. It is essential for the invention that by making the gap 15 as described and by removing from inside it the part 16 an optically clear and planar surface 1.1. of the wall 1 is obtained.

In the example case that has been presented before the dimensions of the piece P are: x and y 15 mm and the dimension z can be for instance 50 µm- 2 mm. With the given values of x and y the outer diameters for the sheets 10, 11 are in this example case about 150 mm. The method according to the invention can be used very widely in connection of different size and thickness sheets. In the market, there are as standard products for instance sheets of the diameter of 2" - 10" and their thicknesses vary in the above-mentioned range 50 µm- 2 mm. The usage of the invention is however not limited only to the production of the pieces P of the presented size but it can be applied widely for different size products. The usage of the invention is not limited to the certain size standard preforms but it can be used much more widely. As an example we can mention to produce pieces P one by one from two small pieces of sheets that are in that case named the first and the second sheet 10, 11 and the mass production of big amounts at the same time making sheets from bigger than standard sheets. Of cause producing certain bigger amount at one time from standard parts gives in most cased the best financial end result.

It is essential for the method according to the invention that the surface clarity and the flatness of a factory produced sheets are exploited to obtain a piece P that is optically clear and the wall 1 with good refraction capabilities. This can be reached using the invention so that neither surface off the wall 1 need to be machined nor and so that shape changing heat stress are not caused in the preforms used in the production of the piece P. It is known that laser ablation does no cause note worthy increase in the temperature. The same applies to the mechanical working because the temperature can be controlled by for instance cooling.

It is possible to produce pieces P of different shapes with the method according to the invention. In addition to rectangular pieces it is possible to make for instance polygons, cylinders, otherwise curvilinear and combinations of these shape pieces. It is essential for those shapes that they can be made by joining two sheets. The inside 2.1 of the rim 2 of the piece P can be made according to the invention method also in many shapes. All the presented methods are possible and the factor that determines the shape of the space 3 can naturally be for instance the shape of the optical device that is to be placed there.

When the ablation is used its advancing speed can be adapted case by case. The focused laser beam 13b that causes the ablation about which the name "picoseconds-laser" is used can have the pulse length of for instance 10 picoseconds and the power can be tens of watts (W) when its advancing speed is a number of meters per second. The laser beam and the ablation advance going round certain circumference and moving deeper with certain movement per round of the material when material disappears or is removed from this spot and a gap 15 is formed in the spot in question. The ablation or other work methods that are used in the method according to the invention do not harm the first surface 1.1 of the wall 1.

It is worth noticing that even though in this description it has been kept to one for invention favorable realization example this does not however mean that the usage of the invention would be limited only to this type of example but many variations are possible within the scope of the claims.

## Claims

1. A method to produce a transparent piece (P) for protecting an optical component, which piece comprises at least one wall (1) that is optically clear and that has planar surfaces, and a rim (2) going round a first surface (1.1) of said wall, wherein a space (3) is formed inside the outer dimensions (x, y, z) of said piece such that the space is limited to said first surface (1.1) and to the inner surface (2.1) of the rim, and which method includes producing one or more pieces (P) as follows:
a. a first sheet (10) and a second sheet (11) are placed against each other, wherein at least that one of said sheets (10,11) which is used to form the wall/walls (1) is optically clear,
b. the surfaces (10.2, 11.1) of said sheets that are against each other are welded together using a focused laser beam (13a) at the level of their common boundary surface (12),
c. said welding comprises forming a circumferential weld (14'), either with a continuous weld or with crossing welds (14), for each piece (P) to be produced,
said method being **characterized by** the following steps:
d. each circumferential weld (14') has a projection line in a thickness direction (w) of said sheets (10,11), wherein a machining is performed inside each projection line to form a peripheral gap (15) that extends through that one of said sheets (10,11) which is used to form the rim / rims of the piece / -s (P),
e. the gap (15) formed at each mentioned machining location separates a part (16) from the machined sheet, the size of said part (16) being substantially equal to the size of said space (3),
f. part / parts (16) are removed from said sheet, wherein a piece (P) is formed or a preform that includes several pieces (P) attached to each other,
g. in case of said preform, pieces (P) are separated from it by cutting along cutting points (100) that are located between the circumferential welds (14') of these pieces.

2. The method according to the claim 1 **characterized thereof that** the raw material of the transparent piece (P) is glass, silicon or sapphire, glass/silicon/sapphire combination, glass/silicon combination, glass sapphire combination, or silicon/sapphire combination.

3. The method according to the claim 1 or 2 **characterized thereof that** the machining of the gap (15) belonging to it is performed by ablation with a focused laser beam (13b), with mechanical work or by laser technique other than ablation.

4. The method according to some of the claims 1 - 3 **characterized thereof that** the piece (P) produced by it is rectangular, polygon or cylinder.

5. The method according to some of the claims 1 - 4 **characterized thereof that** the space (3) of the piece made by it is rectangular, polygon or cylinder.

6. The method according to some of the claims 1 - 5 **characterized thereof that** the circumferential weld (14') is made gas tight.

7. The method according to some of the claims 1 - 6 **characterized thereof that** the first and the second sheets (10, 11) that are used there are factory fabricated sheets.

## Patentansprüche

1. Ein Verfahren zur Herstellung eines transparenten Teils (P) zum Schützen eines optisches Bauteils, wobei das Teil mindestens eine Wand (1), die optisch hell ist und die planare Oberflächen hat, und einen Rand (2) aufweist, der um eine erste Oberfläche (1.1) dieser Wand verläuft, wobei ein Raum (3) innerhalb der Außenabmessungen (x, y, z) des Teils so gebildet ist, dass der Raum auf die erste Oberfläche (1.1) und auf die Innenfläche (2.1) des Randes begrenzt ist, und wobei das Verfahren das Herstellen von einem oder mehreren Teilen (P) wie folgt umfasst:
a) eine erste Scheibe (10) und eine zweite Scheibe (11) werden aneinandergesetzt, wobei zumindest die eine der Scheiben (10, 11), die zum Bilden der Wand/Wände (1) verwendet wird, optisch klar ist,
b) die Oberflächen (10.2, 11.1) der Scheiben, die aneinander anliegen, unter Verwendung eines fokussierten Laserstrahls (13a) auf der Höhe ihrer gemeinsamen Grenzfläche (12) zusammengeschweißt werden,
c) das Schweißen das Bilden einer Umfangsschweißnaht (14') umfasst, entweder mit einer durchgehenden Schweißnaht oder mit kreuzenden Schweißnähten (14), für jedes herzustellende Teil (P),
wobei das Verfahren durch die folgenden Schritte gekennzeichnet ist:
d) jede Umfangsschweißnaht (14') weist eine Projektionsline in einer Dickenrichtung (w) der Scheiben (10, 11) auf, wobei ein Bearbeiten innerhalb jeder Projektionslinie durchgeführt wird, um einen Umfangsspalt (15) zu bilden, der sich durch diejenige der Scheiben (10, 11) erstreckt, die verwendet wird, um den Rand/die Ränder des Teils/der Teile (P) zu bilden,
e) der Spalt (15), der an jedem erwähnten Bearbeitungsort gebildet ist, nimmt ein Teil (16) von der bearbeiteten Scheibe ab, wobei die Größe des Teils (16) im Wesentlichen gleich der Größe des Raumes (3) ist,
f) Teil/Teile (16) werden von der Scheibe abgenommen, wobei ein Teil (P) gebildet wird oder ein Vorformling, der mehrere miteinander verbundene Teile (P) aufweist,
g) im Falle des Vorformlings werden Teile (P) von diesem durch Schneiden entlang der Schnittpositionen (100), die sich zwischen den Umfangsschweißnähten (14) dieser Teile befinden. abgeschnitten.

2. Verfahren gemäß Anspruch 1, **dadurch gekennzeichnet, dass** das Rohmaterial des transparenten Teils (P) Glas, Silizium oder Saphir, Glas/Silizium/Saphir-Kombination, Glas/Silizium-Kombination, Glas/Saphir-Kombination oder Silizium/Saphir-Kombination ist.

3. Verfahren gemäß Anspruch 1 oder 2, **dadurch gekennzeichnet, dass** die Bearbeitung des dazugehörigen Spalts (15) durch Ablation mit einem fokussierten Laserstrahl (13b), mit mechanischer Bearbeitung oder durch eine andere Lasertechnik als Ablation erfolgt.

4. Verfahren gemäß einem der Ansprüche 1 bis 3, **dadurch gekennzeichnet, dass** das dadurch hergestellte Teil (P) rechteckig, vieleckig oder zylindrisch ist.

5. Verfahren gemäß einem der Ansprüche 1 bis 4, **dadurch gekennzeichnet, dass** der Raum (3) des hergestellten Teils rechteckig, vieleckig oder zylindrisch ist.

6. Verfahren gemäß einem der Ansprüche 1 bis 5, **dadurch gekennzeichnet, dass** die Umfangsschweißnaht (14') gasdicht ist.

7. Verfahren gemäß einem der Ansprüche 1 bis 6, **dadurch gekennzeichnet, dass** die erste und zweite Scheibe (10, 11), die dort verwendet werden, fabrikgefertigte Scheiben sind.

## Revendications

1. Procédé pour produire une pièce transparente (P) destinée à protéger un composant optique, laquelle pièce comprend au moins une paroi (1) qui est optiquement claire et qui présente des surfaces planes, et un rebord (2) entourant une première surface (1.1) de ladite paroi, dans lequel un espace (3) est formé à l'intérieur des dimensions extérieures (x, y, z) de ladite pièce, de manière que l'espace soit limité par ladite première surface (1.1) et par la surface intérieure (2.1) du rebord, lequel procédé comprend la production d'une ou de plusieurs pièce(s) (P) de la manière suivante :
a. une première feuille (10) et une seconde feuille (11) sont placées l'une contre l'autre, dans lequel au moins celle desdites feuilles (10, 11) qui est utilisée pour former la ou les paroi(s) (1) est optiquement claire,
b. les surfaces (10.2, 11.1) desdites feuilles qui sont l'une contre l'autre sont soudées entre elles à l'aide d'un faisceau laser focalisé (13a) au niveau de leur surface limite commune (12),
c. ledit soudage comprend la formation d'une soudure circonférentielle (14'), soit en une soudure continue soit en des soudures en croix (14), pour chaque pièce (P) à produire,
ledit procédé étant **caractérisé par** les étapes suivantes :
d.chaque soudure circonférentielle (14') a une ligne de projection dans le sens de l'épaisseur (w) desdites feuilles (10, 11), dans lequel un usinage est réalisé à l'intérieur de chaque ligne de projection pour former un écartement périphérique (15) qui s'étend à travers celle desdites feuilles (10, 11) qui est utilisée pour former le(s) rebord(s) de la ou des pièce(s) (P),
e. l'écartement (15) formé à chaque emplacement d'usinage mentionné sépare une partie (16), de la feuille usinée, la taille de ladite partie (16) étant sensiblement égale à la taille dudit espace (3),
f. la ou les partie(s) (16) est ou sont retirée(s) de ladite feuille, dans lequel est formée une pièce (P) ou une préforme qui comprend plusieurs pièces (P) fixées les unes aux autres,
g.dans le cas de ladite préforme, les pièces (P) en sont séparées par découpage le long de points de coupe (100) qui sont situés entre les soudures circonférentielles (14') de ces pièces.

2. Procédé selon la revendication 1, **caractérisé en ce que** la matière première de la pièce transparente (P) est du verre, du silicium ou du saphir ou encore une combinaison de verre-silicium-saphir, une combinaison de verre-silicium, une combinaison de verre-saphir ou une combinaison de silicium-saphir.

3. Procédé selon la revendication 1 ou 2, **caractérisé en ce que** l'usinage de l'écartement (15) qui en fait partie est réalisé par ablation à l'aide d'un faisceau laser focalisé (13b), d'un travail mécanique ou d'une technique laser autre que l'ablation.

4. Procédé selon l'une des revendications 1 à 3, **caractérisé en ce que** la pièce (P) produite au moyen de celui-ci est rectangulaire, polygonale ou cylindrique.

5. Procédé selon l'une des revendications 1 à 4, **caractérisé en ce que** l'espace (3) de la pièce réalisée au moyen de celui-ci est rectangulaire, polygonal ou cylindrique.

6. Procédé selon l'une des revendications 1 à 5, **caractérisé en ce que** la soudure circonférentielle (14') est rendue étanche aux gaz.

7. Procédé selon l'une des revendications 1 à 6, **caractérisé en ce que** les première et seconde feuilles (10, 11) qui y sont utilisées sont des feuilles de fabrication industrielle.
